Europäisches Patentamt

European Patent Office

Office européen des brevets

(19)

(11)  **EP 1 204 208 A2**

(12)  **EUROPÄISCHE PATENTANMELDUNG**

(43)  Veröffentlichungstag:
08.05.2002  Patentblatt 2002/19

(51)  Int Cl.⁷: **H03H 17/02**

(21)  Anmeldenummer: 01123015.8

(22)  Anmeldetag: 26.09.2001

(84)  Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(30)  Priorität: **18.10.2000  DE 10051672**

(71)  Anmelder: **ROBERT BOSCH GMBH
70442 Stuttgart (DE)**

(72)  Erfinder:
  • **Goeckler, Heinz, Prof. Dr.
71522 Backnang (DE)**
  • **Groth, Alexandra
44789 Bochum (DE)**

(54)  **FDM-Demultiplexer-Filterbank sowie FDM-Multiplexer-Filterbank**

(57)  Für eine FDM-Demultiplexer-Filterbank werden die Abtastraten der Filterbank sowohl an der Symbolrate als auch am Kanalraster orientiert, mit der die Einzelkanalsignale im FDM-Signal übertragen werden.

Fig. 1

**Beschreibung**

Stand der Technik

Zur Übertragung von Daten, die voneinander unabhängig sind, über eine erforderliche Anzahl von Einzelkanälen im Frequenzmultiplex benötigt man digitale Filterbänke zur Zusammensetzung der FDM-Signale aus den Einzelkanalsignalen (FDM-Multiplexer mit nachfolgender D/A-Umsetzung) beziehungsweise digitale Filterbänke zur Trennung des FDM-Signals in Einzelkanalsignale (FDM-Demultiplexer mit vorgeschalteter A/D-Umsetzung) [1]. Häufig sind nicht nur die einzelnen Datensignale voneinander unabhängig, sondern auch die Daten- beziehungsweise Symbolraten. In diesen Fällen wird dann die Taktrate (Abtastfrequenz) der jeweiligen Filterbank unabhängig von der Vielzahl der relativ zueinander asynchronen Daten- beziehungsweise Symbolraten der Einzelkanalsignale gewählt. Deshalb ist z. B. in Empfängern für Datensignale im Frequenzmultiplex für jeden Einzelkanal eine Synchronisationseinrichtung vorzusehen, um die Symbolrate für die Weiterverarbeitung der Daten zurückzugewinnen [2].

In [1] sind drei verschiedene Prinzipien zur digitalen Realisierung von Filterbänken zum Demultiplexen von FDM-Signalen beschrieben. [3] gibt einen noch umfassenderen Überblick über Filterbankverfahren. Duale Filterbänke (Frequenzmultiplexer) zur Zusammenführung von Einzelkanalsignalen zu FDM-Signalen erhält man aus den Demultiplexer-Filterbänken durch Transponierung des jeweiligen Signalflußgraphen [4]. Charakteristisch für die angeführten FDM-Demultiplexer-Filterbänke ist, dass die Wahl der jeweiligen Abtastfrequenz ausschließlich unter dem Gesichtspunkt vorgenommen wird, dass die Filterbank für die Signalverarbeitung möglichst wenig Eigenaufwand benötigt. Dies wird dadurch erreicht, dass die Abtastfrequenz

a1) unabhängig von den jeweiligen Inhalten der Einzelkanäle gewählt wird, z. B. asynchrone Übertragung von Daten,

b1) sich am Kanalraster orientiert und infolgedessen mindestens gleich dem zweifachen Wert (zur Einhaltung des Abtasttheorems für reelle Signale) der Summe der Einzelkanalbandbreiten ist, gegebenenfalls unter Einbeziehung unbenutzter Kanäle am Rande des Übertragungsbandes,

c1) der jeweiligen Bandbreite der Teil-FDM- oder Einzelkanalsignale angepaßt wird und dass

d1) effiziente Filterbankalgorithmen (Polyphasen-Methode, hierarchische Baumstrukturen) verwendet werden.

Vorteile der Erfindung

Die FDM-Demultiplexer-Filterbank gemäß Anspruch 1 sowie die FDM-Multiplexer-Filterbank nach Anspruch 19 ist geeignet für den Einsatz in Zusammenhang mit höchsteffektiven FilterbankAlgorithmen, die sich am Kanalraster orientieren. Im Gegensatz zu einer Orientierung allein an der Symbolrate entsteht keine Überlappung der Filterdurchlaßbereiche und damit eine unproblematische Signalbehandlung. Zumindest für eine Eingangsstufe, wo die Abtastfrequenz am höchsten ist und oft technologiebedingt kritisch ist, kann eine gemeinsame Signalverarbeitung erfolgen. Es muss für die Einzelkanalsignale lediglich ein effizienter Abtastratenumsetzer zur Erhöhung der Abtastrate um den ganzzahligen Faktor L und zur Verminderung um den ganzzahligen Faktor M nachgeschaltet werden. Trotz der Einschränkung bezüglich des Kanalrasters und der Symbolrate ermöglicht die Erfindung, digitale Filterbänke zum (De-) Multiplexen von FDM-Signalen zu realisieren, die recheneffizient und damit kostengünstig sind, infolge dessen auch einen geringen Leistungsverbrauch aufweisen und somit für eine hochintegrierte Realisierung geeignet sind.

In den Unteransprüchen sind vorteilhafte Ausgestaltungen der Erfindung angegeben.

Wegen des Zusammenhangs zwischen den dualen Operationen FDM-Demultiplexen und FDM-Multiplexen über die Verfahren der Transponierung [4] kann auch eine entsprechende FDM-Multiplexer-Filterbank realisiert werden (Anspruch 19).

Durch die Maßnahmen der Patentansprüche lassen sich FDM- (De-) Multiplexer-Filterbänke realisieren

a2) deren (Eingangs- und jegliche Zwischen-) Abtastraten unter gewissen Einschränkungen durch das verwendete Kanalraster in einem festen und eindeutigen Verhältnis zu den synchronen Symbolraten der Einzelkanäle stehen, wobei in einer Weiterbildung der Erfindung auch unterschiedliche, in einem ganzzahligen Verhältnis stehende Symbolraten zulässig sind,

b2) wobei alle möglicherweise auftretenden Zwischenabtastraten (mit Ausnahme der Eingangsabtastrate) unterhalb einer technologieabhängigen Obergrenze liegen, z. B. CMOS-Technologie 100 MHz,

c2) wobei die vorgenannten Möglichkeiten c1) und d1) unter den durch die Einschränkungen a2) und b2) gegebenen Randbedingungen optimal zur Realisierung der Filterbänke mit minimalem Rechenaufwand genutzt werden,

d2) und wobei die Eingangsabtastrate angemessen über dem durch das Abtasttheorem vorgegebenen Minimalwert liegt, damit die vor der Abtastung erforderliche Bandbegrenzung des analogen FDM-Signals aufwandsgünstig und ausreichend unempfindich realisierbar ist, ohne dass die Verarbeitungsrate in der digitalen Filterbank über Gebühr erhöht wird.

Zeichnungen

Anhand der Zeichnungen werden Ausführungsbeispiele der Erfindung erläutert. Es zeigen

Figur 1 eine dreistufige Filterbank,

Figur 2 bis Figur 6 Signalspektren an den Ein- und Ausgängen von Teil-Filterbänken,

Figur 7 die synchrone Umsetzung der Abtastrate der Einzelkanalsignale um den Faktor Lm'/M.

Beschreibung von Ausführungsbeispielen

Bei der erfindungsgemäßen Realisierung einer FDM-Demultiplexer-Filterbank sind die Abtastraten sowohl an der Symbolrate als auch am Kanalraster orientiert, mit der die Einzelkanalsignale im FDM-Signal übertragen werden.

Die Filterbank ist derart ausgebildet, dass das FDM-Signal am Kanalraster orientiert in Einzelkanalsignale zerlegt wird, die mit einer Abtastrate $\frac{L}{M}$ $f_s$ abgebbar sind, wobei L, M $\in$ |N und $f_s$ die Symbolrate darstellt, mit der die Daten im FDM-Signal übertragen werden. Die Symbolrate $f_s$ wiederum ist mit einem jeweils nachgeschalteten, Abtastratenumsetzer auf die ausgangsseitige Abtastrate m x $f_s$ mit m $\in$ {2, 3, 4,...} umsetzbar.

Die erfindungsgemäße Filterbank stützt sich auf folgende Einzelmaßnahmen, die einzeln oder in Kombination realisierbar sind, wenn sie nicht alternativ zueinander sind:

1. Einspeisung eines reellwertigen FDM-Signals mit einer Eingangsabtastfrequenz $f_A$ = Mqf$_S$ > 2 x die Summe aller Einzelkanalbandbreiten (M $\in$ |N, m $\in$ |N) , $f_s$: Symbolrate, q = $\frac{N}{L}$ (N, L $\in$ |N)

2. Zerlegung des FDM-Signals in Einzelkanalsignale mittels der Polyphasen-Methode [1, 3, 4]

   a) entweder in einem Schritt bei gleichzeitiger Verminderung von $f_A$ = Mqf$_S$ auf qf$_S$ am Ausgang der Polyphasen-Filterbank

   b) oder mehrstufig mit I Stufen, wobei jeweils in Teil-FDM-Signale zerlegt wird, bei gleichzeitiger Verminderung der Abtastrate um einen entsprechenden Faktor $M_i$ mit

$$\prod_{i=1}^{I} M_i = M,$$

und für die erste Stufe $M_1$ > $M_{min}$ gilt derart, dass

$$f_A/M_1 < f_A^{max},$$

wobei

$$f_A^{max}$$

eine technologiebedingt höchstmögliche Abtastrate ist,

3. die Polyphasen (Teil-) Filterbänke sind mit komplexen Koeffizienten realisiert, so dass die Ausgangssignale der (Teil-) Filterbänke komplexwertig sind,

4. die Durchlaßbandbreiten der verschiedenen (Teil-) Filterfrequenzgänge der (Teil-) Filterbänke entsprechen den Einzelkanalbandbreiten beziehungsweise der Summe der Einzelkanalbandbreiten bei Teil-FDM-Signalen; damit tritt keine Überlappung von Teilfilterfrequenzgängen ein,

5. jedes zweite komplexe Ausgangsnutzsignal wird in einem Mischer um die jeweilige halbe Ausgangsabtastfrequenz frequenzverschoben,

6. bei Bedarf wird mittels eines synchronen Dezimators [4] die Abtastrate der Einzelkanalsignale von qf$_s$ = $\frac{N}{L}$ $f_s$ auf m'f$_s$ umgesetzt durch Erhöhung um den Faktor Lm' und nachfolgender Verminderung um N (N, L, m' $\in$ |N).

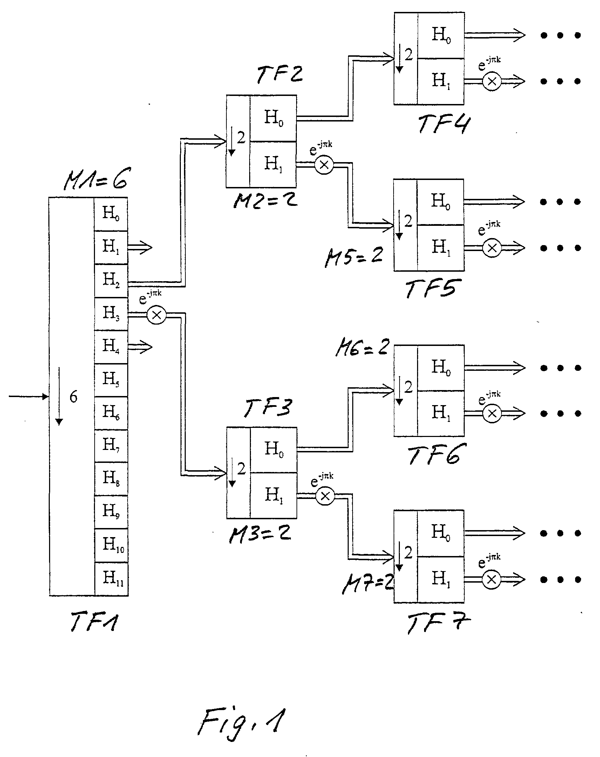

Figur 1 zeigt hierfür ein Ausführungsbeispiel. Hier wurde eine mehrstufige Filterbank in Baumstruktur mit den Teilfilterbänken TF1, TF2 bis TF7 gewählt mit den Dezimationsfaktoren für die Abtastraten $M_1$ = 6, $M_2$ = 2 ... = $M_7$ = 2.

Nur vier der 6 möglichen Teil-FDM-Signale werden weiterverarbeitet, da die restlichen zwei zur Vereinfachung der analogen Filterung vor der nachfolgenden Analog-Digital-Umsetzung nicht genutzt werden. Die Stufen TF2 bis TF7 mit M2 bis M7 zerlegen das jeweilige Teil-FDM-Signal jeweils in Verbindung mit einer Abtastratenhalbierung in zwei Signale halber Kanalzahl. Ausgangsabtastrate der Filterbaumstruktur ist damit q · $f_s$ mit q = 2,6 = $\frac{13}{5}$. Mit dem technologiebedingten

Wert

$$f_A^{max} = 50 \text{ MHz}$$

kann die Eingangsabtastrate 300 MHz betragen.

Die Zerlegung des FDM-Signals in mehreren Schritten hat den weiteren Vorteil, dass am Ausgang einer Teilfilterbank wahlweise Einzelkanalsignale mit einer größeren Bandbreite beziehungsweise Symbolrate auskoppelbar sind, z. B. 32-fach nach der dritten Stufe TF3. Mit H sind die jeweiligen Übertragungsfunktionen der Teilfilter in Figur 1 bezeichnet.

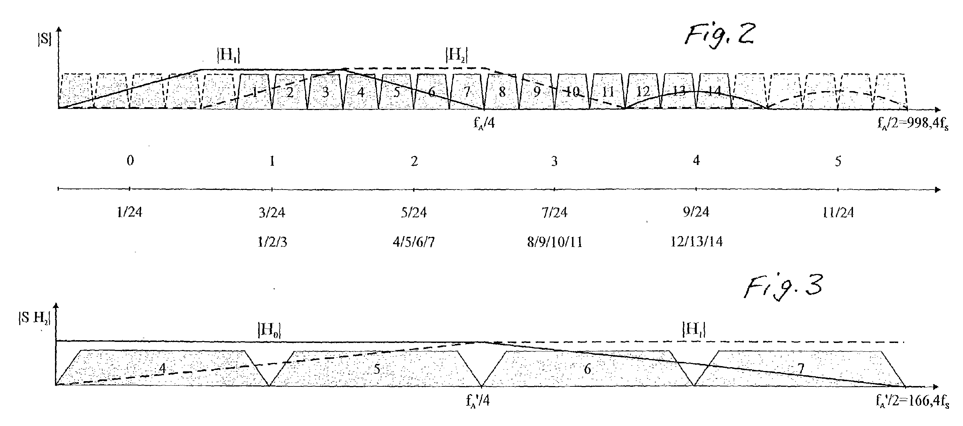

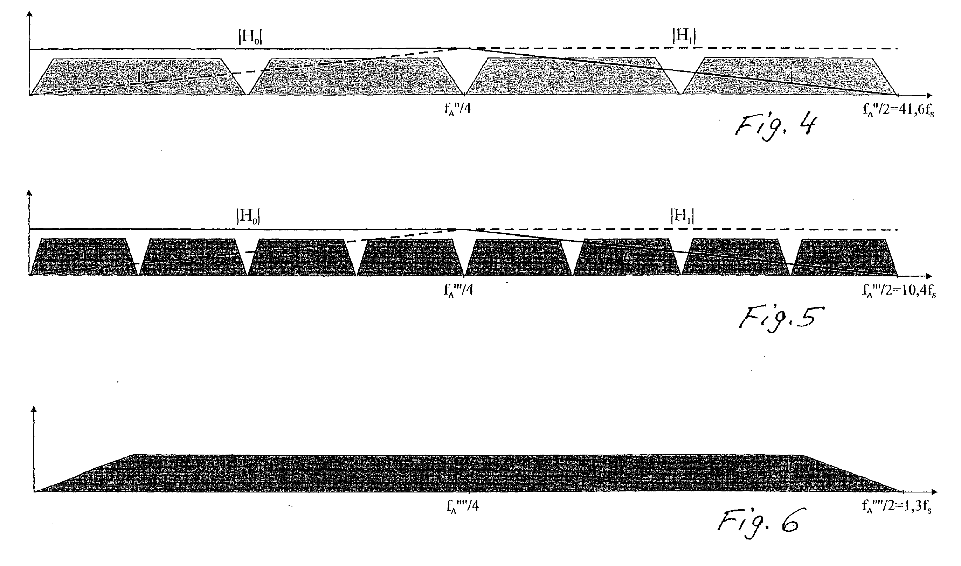

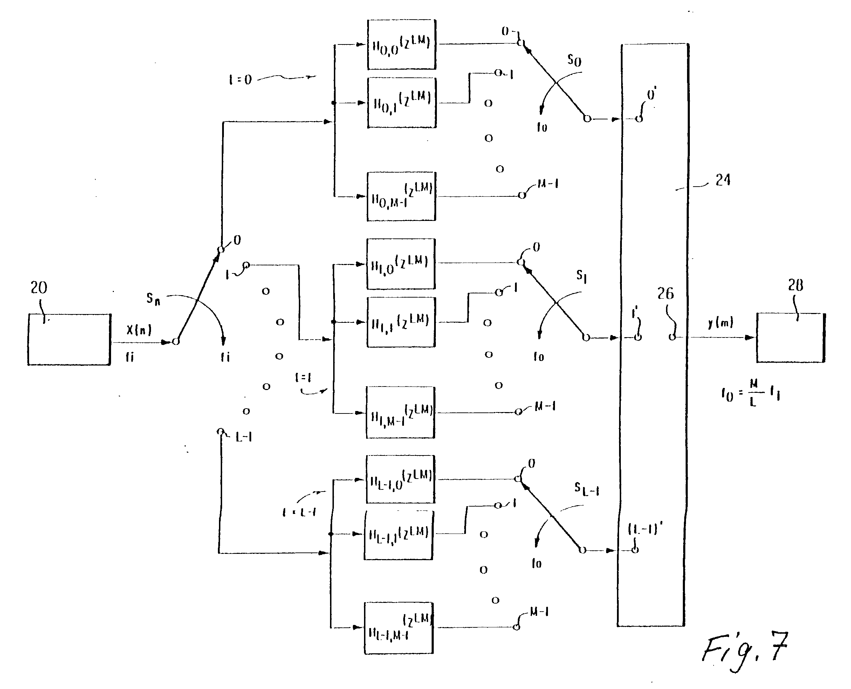

Die Figuren 2 bis 6 zeigen die zugehörigen Spektren an den Ein- und Ausgängen der (Teil-) Filterbänke. In Figur 2 ist das Eingangssignal der Teilfilterbank TF1 dargestellt. Es wurde eine Abtastfrequenz $f_A$ = 1996,8 $f_s$ und eine Ausgangssamplingrate 2,6 $f_s$ verwendet. Unter der Bezugsachse für die Abtastfrequenz $f_A$ sind jeweils zuerst die Filternummern, dann die Verschiebung des Prototypfilters um entsprechende Bruchteile und zuletzt die Nummern der jeweils gefilterten Spektren aufgeführt. Es sind 14 der 24 maximal möglichen Einzelkanäle der höchsten vorkommenden Bandbreite dargestellt. Figur 3 zeigt ein Signalspektrum am Ausgang der Teilfilterbank TF1, also nach einer Dezimation um 6. Statt einem Einzelkanal der höchstmöglichen Bandbreite sind in Figur 3 in diesem Frequenzband, den ein solcher Kanal erfordern würde, 4 Kanäle mit einem Viertel dieser Bandbreite dargestellt. Die dargestellten Kanäle der Figur 3 sind daher nicht mit den Kanälen der Figur 2 identisch. Die Figuren 4 bis 6 zeigen Signalspektren am Ausgang der Teilfiterbänke nach jeweils einer Dezimation um den Faktor 2 in Verbindung mit einer Abtastratenhalbierung.

Für die erfindungsgemäße Filterbank lassen sich die folgenden Ausgestaltungen realisieren, die einzeln oder in Kombination angewendet werden können:

1. Alle Filterbänke zerlegen das jeweilige Teil-FDM-Signal in Verbindung mit einer Abtastratenhalbierung in zwei Signale halber Kanalzahl mit Ausnahme der ersten Stufe, die auf der Basis der Polyphasen-Filterbank-Methode das reellwertige Eingangssignal orientiert am Kanalraster so weit in Teil-FDM-Signale zerlegt, dass die in dieser ersten Stufe erforderliche Abtastrate unter

$$f_A^{max}$$

liegt.

2. Als Prototyp-Filter für die Polyphasen-Filterbänke werden nicht rekursive (FIR) Filter eingesetzt mit

- linearer Phase,
- minimaler Phase,
- geebneter Laufzeit, das heißt es wurde eine Laufzeitentzerrung vorgenommen

3. Prototypfilter: rekursiv

- mit minimaler Phase,
- laufzeitentzerrt (geebnet).

4. Bandpaßabtastung des Eingangssignals unter der Vorraussetzung, dass das reellwertige FDM-Signal am Systemeingang wenigstens näherungsweise bei der Frequenz $f_c = (1 \pm \frac{1}{4}) f_A = (1 \pm \frac{1}{4}) Mqf_S$ ($1 \in |N$) zentriert ist.

5. Bandpaßabtastung unter der Voraussetzung, dass bei gegebener Mittenfrequenz $f_c$ des reellwertigen analogen FDM-Eingangssignals und gegebener Symbolrate $f_s$ der Gesamtdezimationsfaktor D = M · n beziehungsweise M · q sich ergibt zu D = $\frac{4}{4l+1} \frac{f_c}{f_s}$ und für die Eingangsabtastfrequenz gilt: $f_A = D \cdot f_s$.

6. Bei einer vorgegebenen Mittenfrequenz $f_c$, die für $M_{min}$ nicht obige Bedingung (4.) erfüllt, führt eine Erhöhung von $M_1$ auf $M_1 > M_{min}$ zu einem geeigneten Wert bezüglich $f_c$.

7. Bei $M \neq 2^i$ mit $i \in |N$ wird $M_1$ zu $M_1 = M/2^j$ ($j \in |N$, $j \leq i_{max}$ festgelegt unter Beachtung der Bedingung für

$$f_A^{max}$$

8. Wahl genau der Ausgänge der ersten Stufe TF1 der hierachischen Filterbank derart, dass alle Einzelkanalsignale in Kehrlage oder Regellage abgegeben werden.

Die zuvor angegebene Umsetzung der Abtastrate der Einzelkanalsignale um den Faktor Lm' /M kann gemäss [5] (dort Figur 3) vorgenommen werden. Figur 7 zeigt das Prinzip in einem Schaltbild. Mit dem Bezugszeichen 20 ist die Signalquelle und mit 28 die Signalsenke bezeichnet. Das Bezugszeichen 24 bezeichnet eine Summierstufe. Weitere Details können der US 4,725,972 [5] entnommen werden.

Bisher wurde nur von FDM-Demultiplexer-Filterbänken ausgegangen.

Entsprechende FDM-Multiplexer-Filterbänke lassen sich wegen des Zusammenhangs zwischen den dualen Operationen FDM-Demultiplexen und FDM-Multiplexen über die Verfahren der Transponierung [4] realisieren, das heißt der Eingang des einen Systems wird zum Ausgang des anderen/neuen Systems und umgekehrt. Die Eingangsabtastrate wird zur Ausgangsabtastrate und umgekehrt. Anstelle der in Figur 3 vorgesehenen Abwärtstaster (Dezimatoren) sind dann entsprechende Aufwärtstaster (Interpolatoren) vorgesehen.

Literaturverzeichnis:

[1] Göckler, Eyssele: "Study of on-board digital FDM-demultiplexing for mobile SCPC satellite communications". Europ. Trans. Telecomm. ETT-3 (1992, Seiten 7 bis 30).

[2] Alberti, Hespelt, Göckler: "A digital multicarrier demodulator with fast synchronisation for mobile SCPS satellite communications". Int. Conf. Dig. Satellite Communications, Guadaloupe, April 89, Tagungsband Seiten 491 bis 498.

[3] Scheuermann, Göckler: "A comprehensive survey of digital transmultiplexing methods". Proceeding of the Inst. Eletrical and Electronics Engineers (IEEE), New York, USA, 69 (1981) 11, Seiten 1419 bis 1450.

[4] Crochiere, Rabiner: "Multirate Digital Signal Processing". Prentice-Hall, USA 1983.

[5] US-Patent 4,725,972

**Patentansprüche**

1. FDM-Demultiplexer-Filterbank zur Zerlegung eines FDM-Multiplexsignals mit folgendem Merkmal:

   - die Abtastraten der Filterbank orientieren sich sowohl an der Symbolrate, mit der die Einzelkanalsignale im FDM-Signal übertragen werden, wie auch am Kanalraster.

2. FDM-Demultiplexer-Filterbank nach Anspruch 1, **dadurch gekennzeichnet, dass** die Filterbank derart ausgebildet ist, dass das FDM-Signal am Kanalraster orientiert in Einzelkanalsignale zerlegt wird, die mit einer Abtastrate $\frac{L}{M} f_s$ abgebbar sind, wobei L, M $\in$ IN und $f_s$ die Symbolrate ist, die wiederum mit einem jeweils nachgeschalteten Abtastratenumsetzer auf die filterausgangsseitige Abtastrate $mxf_s$, wobei m $\in$ {2, 3, 4,...} ist, umsetzbar ist.

3. Filterbank nach Anspruch 1 oder 2, **dadurch gekennzeichnet, dass** die Eingangsabtastfrequenz $f_A$ für die Filterbank gewählt ist zu $f_A = Mqf_S > 2 \times$ die Summe aller Einzelbandbreiten mit M $\in$ IN, q = N/L; L,N $\in$ IN und $f_S$ = Symbolrate.

4. Filterbank nach einem der Ansprüche 1 bis 3, **dadurch gekennzeichnet, dass** zur Zerlegung des FDM-Signals in Einzelkanalsignale die Polyphasen-Methode vorgesehen ist.

5. Filterbank nach Anspruch 4, **dadurch gekennzeichnet, dass** die Zerlegung des FDM-Signals entweder in einem Schritt bei gleichzeitiger Verminderung von $f_A = M \cdot q\ f_s$ auf $qf_S$ am Ausgang der Polyphasen-Filterbank vorgenommen wird oder mehrstufig mit I Stufen, wobei jeweils eine Zerlegung in Teil-FDM-Signale vorgesehen ist bei gleichzeitiger Verminderung der Abtastrate um einen entsprechenden Faktor $M_i$ mit

$$\prod_{i=1}^{I} M_i = M,$$

und für die erste Stufe $M_1 > M_{min}$ gilt derart, dass

$$f_A/M_1 < f_A^{max},$$

wobei

$$f_A^{max}$$

eine vorgegebene, insbesondere technologiebedingte höchstmögliche Abtastrate ist.

6. Filterbank nach einem der Ansprüche 4 oder 5, **dadurch gekennzeichnet, dass** die Polyphasen (Teil-) Filterbänke mit komplexen Koeffizienten realisiert sind, so dass die Ausgangssignale der (Teil-) Filterbänke komplexwertig sind.

7. Filterbank nach Anspruch 5 oder 6, **dadurch gekennzeichnet, dass** die Durchlaßbandbreiten der verschiedenen (Teil-) Filterfrequenzgänge der (Teil-) Filterbänke entsprechend den Einzelkanalbandbreiten beziehungsweise der Summe der Einzelkanalbandbreiten bei Teil-FDM-Signalen gewählt sind.

8. Filterbank nach Anspruch 6 oder 7, **dadurch gekennzeichnet, dass** mindestens ein Mischer vorgesehen ist, mittels dessen jedes zweite komplexe Ausgangsnutzsignal um die jeweilige halbe Ausgangsabtastfrequenz frequenzverschiebbar ist.

9. Filterbank nach einem der Ansprüche 1 bis 8, **dadurch gekennzeichnet, dass** ein Dezimator vorgesehen ist, mittels dessen die Abtastrate der Einzelkanalsignale von q $\cdot f_S = (N/L) f_s$ auf $m'f_s$ umsetzbar ist, insbesondere durch Erhöhung um den Faktor Lm' und nachfolgender Verminderung um N (N, L, m' ∈ |N).

**10.** Filterbank nach einem der Ansprüche 5 bis 9, **dadurch gekennzeichnet, dass** die Zerlegung des FDM-Signals in mehreren Stufen erfolgt, derart, dass am Ausgang einer Stufe/Teil-Filterbank (TF1) wahlweise Einzelkanalsignale mit einer höheren Bandbreite beziehungsweise Symbolrate bezogen auf den Ausgang der Filterbank auskoppelbar sind, z. B. 32-fach nach der dritten Stufe.

**11.** Filterbank nach einem der Ansprüche 1 bis 10, **dadurch gekennzeichnet, dass** bei einer mehrstufigen Zerlegung des FDM-Signals die Teilfilterbänke (TF1, TF2, ... TF7) so ausgestaltet sind, dass alle Teilfilterbänke mit Ausnahme der ersten eingangsseitigen Teilfilterbank (TF1), das jeweilige Teil-FDM-Signal in Verbindung mit einer Abstratenhalbierung in zwei Signale halber Kanalzahl zerlegen und dass die erste eingangsseitige Teilfilterbank (TF1) so ausgebildet ist, dass sie auf der Basis der Polyphasen-Filterbank-Methode das reellwertige Eingangssignal soweit in Teil-FDM-Signale zerlegt, dass die in dieser ersten Teilfilterbank (TF1) erforderliche Abtastrate unter einem vorgegebenen, insbesondere technologiebedingten höchstmöglichen Maximalwert

$$f_A^{max}$$

liegt.

**12.** Filterbank nach einem der Ansprüche 4 bis 11, **dadurch gekennzeichnet, dass** die Polyphasen-Filterbänke als nicht rekursive (FIR-Filter) mit insbesondere linearer Phase, minimaler Phase und laufzeitentzerrt ausgebildet sind.

**13.** Filterbank nach einem der Ansprüche 4 bis 11, **dadurch gekennzeichnet, dass** die Polyphasen-Filterbänke als rekursive Filter mit insbesondere minimaler Phase und laufzeitentzerrt ausgebildet sind.

**14.** Filterbank nach einem der Ansprüche 1 bis 13, **dadurch gekennzeichnet, dass** am Eingang der Filterbank eine Bandpassabtastung des zugeführten Signals vorgesehen ist, wobei ein reellwertiges zugeführtes FDM-Signal wenigstens näherungsweise bei der Frequenz $f_c = (1 \pm ¼) f_A = (1 \pm ¼) Mqf_S$ zentriert ist mit $1 ∈ |N, M ∈ |N, m ∈ \{2, 3, 4, ...\}$, $f_A$ = Eingangsabtastfrequenz und $f_S$ = Symbolrate.

**15.** Filterbank nach einem der Ansprüche 4 bis 13, **dadurch gekennzeichnet, dass** bei einer vorgegebenen Mittenfrequenz $f_c$ für das Filtereingangssignal, die die Bedingung $f_c = (1 \pm ¼) f_A = (1 \pm ¼) Mqf_S$ für

$M_{min}$ nicht erfüllt, eine Erhöhung der Abtastrate $M_1$ auf $M_1 > M_{min}$ erfolgt, um einen geeigneten Wert für $f_c$ zu erhalten.

**16.** Filterbank nach Anspruch 15, **dadurch gekennzeichnet, dass** bei vorgegebener Mittenfrequenz $f_c$ des reellwertigen analogen FDM-Eingangssignals und gegebener Symbolrate $f_s$ der Gesamtdezimationsfaktor $D = M · m$ beziehungsweise Mq zu $D = \frac{4}{4l\pm1} \frac{f_c}{f_s}$ gewählt ist, wobei für die Eingangsabtastfrequenz $f_A = D · f_s$ gilt.

**17.** Filterbank nach einem der Ansprüche 5 bis 16, **dadurch gekennzeichnet, dass** bei einem Faktor M $\neq 2^i$ für die Abtastrate der Faktor $M_1$ für die Abtastrate der eingangsseitigen Teilfilterbank (TF1), zu $M_1 = M/2^j$ ($i, j ∈ |N, j \leq i_{max}$) gewählt wird unter Beachtung der Bedingung für die Abtastrate

$$f_A/M_1 \; < \; f_A^{max}.$$

**18.** Filterbank nach einem der Ansprüche 1 bis 17, **dadurch gekennzeichnet, dass** bei einem mehrstufigen hierarchischen Aufbau der Filterbank, die Ausgänge der ersten Stufe (TF1) derart mit den Eingängen nachgeordneter Stufen verbunden sind, dass alle Einzelkanalsignale entweder in Regellage oder in Kehrlage am Ausgang der Filterbank abgreifbar sind.

**19.** FDM-Multiplexer-Filterbank nach einem der Ansprüche 1 bis 18, unter Beachtung der allgemeinen Regeln für die Transponierung von Multiraten-Systemen.

Fig. 1

Fig. 2

Fig. 3

$|H_0|$      $|H_1|$

$f_A''/4$      $f_A''/2=41,6f_s$

*Fig. 4*

$|H_0|$      $|H_1|$

$f_A'''/4$      $f_A'''/2=10,4f_s$

*Fig. 5*

$f_A''''/4$      $f_A''''/2=1,3f_s$

*Fig. 6*

Fig. 7